# EUROPEAN PATENT SPECIFICATION

(11) **EP 4 017 232 B1**
(45) Date of publication and mention of the grant of the patent: **28.08.2024**
(21) Application number: 20899235.4
(22) Date of filing: 27.09.2020
(51) Int. Cl.: H05K 7/20, F21V 29/83, H05K 7/14, F21V 15/01, H05K 5/02

(54) **HEAT DISSIPATION DEVICE**
WÄRMEABLEITUNGSVORRICHTUNG
DISPOSITIF DE DISSIPATION DE CHALEUR

(30) Priority: 13.12.2019 CN 201911285515
(43) Date of publication of application: 22.06.2022
(73) Proprietor: ZTE Corporation, Shenzhen, Guangdong 518057 (CN)
(72) Inventor: WANG, Kai, Shenzhen, Guangdong 518057 (CN)
(74) Representative: Savi, Massimiliano
(86) International application number: PCT/CN2020/118101
(87) International publication number: WO 2021/114823

(56) References cited:
- CN-A- 105 555 082
- CN-A- 106 852 046
- CN-A- 106 982 537
- CN-A- 107 979 950
- CN-A- 109 585 732
- CN-A- 109 981 867
- CN-U- 204 231 854
- CN-U- 209 043 090
- US-A1- 2019 099 286

## Description

### TECHNICAL FIELD

Embodiments of the present disclosure relate to the field of hardware equipment, and in particular, to a heat dissipation device.

### BACKGROUND

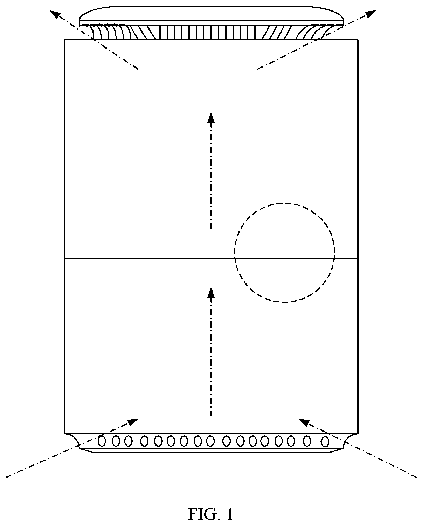

Due to considerable heat generation, current network access equipment adopts fixed hole for heat dissipation, which has relatively concealed hole positions and limited heat dissipation. As shown in FIG. 1, small holes are opened at a bottom groove. Cold air is sucked from the bottom through the heat convection of air, passes through heat generation components on a mainboard and metal heat dissipation blocks, and is discharged from the top through convection to implement heat exchange. However, due to a long path of the entire heat exchange process, concealed hole positions, blockage of air by internal structures, and other reasons, heat generation cannot be effectively mitigated at an intermediate component position such as a circular position in FIG. 1.

For the foregoing problems in some cases, there is currently no effective solution yet.

CN106852046A discloses a novel outdoor electronic device box. The novel outdoor electronic device box comprises an outer box body, an inner box body and a lifting mechanism. The inner box body is sleeved with an outer box body capable of sliding up and down, the lifting mechanism driving the outer box body to move up and down is arranged on the inner box body, a threading hole is formed in the bottom of the inner box body, and a box door capable of achieving opening and closing is arranged on the widest outer side face of the inner box body; the outer box body comprises a main body and a box cover arranged at the upper end of the main body, the main body comprises a first groove, a second groove, two inserting bodies and two inserting grooves, the inserting bodies are arranged at the lower end of a front body of the first groove and the upper end of a back body of the second groove, and the inserting grooves are formed in the lower end of a back body of the first groove and the upper end of a front body of the second groove.

### SUMMARY

The invention is defined by independent claim 1. Embodiments of the present disclosure provide a heat dissipation device, to solve at least to some extent one of the related technical problems including a problem that in some cases a heat dissipation manner in which small holes are opened at the bottom and the top of an apparatus to allow cold air to be sucked in from the bottom and discharged from the top through convection to implement heat exchange has low heat dissipation efficiency.

According to an embodiment of the present disclosure, a heat dissipation device is provided. The heat dissipation device includes a housing. The housing includes a first sub-housing and a second sub-housing, the second sub-housing is adjacent to a bottom of the heat dissipation device, and the first sub-housing is adjacent to a top of the heat dissipation device. One or more holes are provided in a part of the second sub-housing that is overlapping the first sub-housing, the first sub-housing and the second sub-housing are capable of relative movement, and the relative movement is capable of exposing the one or more holes provided in the second sub-housing to form an air duct.

### BRIEF DESCRIPTION OF DRAWINGS

The accompanying drawings described herein are intended to provide a further understanding of the present disclosure, and constitute a part of the present disclosure. The illustrative embodiments of the present disclosure and the description thereof are intended to describe the present disclosure, and do not constitute a limitation to the present disclosure. In the accompanying drawings:
FIG. 1 is a schematic structural diagram of a heat dissipation device in some cases;
FIG. 2 is a schematic structural diagram of a heat dissipation device according to an embodiment of the present disclosure;
FIG. 3 is a schematic structural diagram one of a heat dissipation device according to an embodiment of the present disclosure;
FIG. 4 is a schematic structural diagram two of a heat dissipation device according to an embodiment of the present disclosure;
FIG. 5 is a schematic structural diagram three of a heat dissipation device according to an embodiment of the present disclosure;
FIG. 6 is a schematic structural diagram four of a heat dissipation device according to an embodiment of the present disclosure; and
FIG. 7 is a schematic structural diagram five of a heat dissipation device according to an embodiment of the present disclosure.

### DETAILED DESCRIPTION

The present disclosure is described below in detail with reference to the accompanying drawings and in combination with the embodiments. It is to be noted that the embodiments in the present disclosure and the features in the embodiments may be combined with each other if not conflicted.

It is to be noted that the terms such as "first" and "second" in the description, claims and the foregoing accompanying drawings of the present disclosure are only intended to distinguish between similar objects, but are not necessarily intended to describe a specific sequence or a precedence order.

5G technology can bring users better user experience with transmission rates much higher than those of previous cellular networks, which may be up to 10 Gbit/s. Another advantage of 5G technology is low network latency and faster response speed. Due to outstanding advantages, 5G technology can meet application scenarios of large data transmission such as high-definition videos and virtual reality as well as low latency scenarios such as autonomous driving and telemedicine. However, the implementation of 5G places higher demands on hardware systems. High rates, low latency, multiple antennas, and other needs put more demanding requirements on heat generation scenarios of hardware. Current 4G terminals have relatively low power consumption because of low rates. In the 5G era, as the sizes of terminals remain unchanged, the power consumption of the terminals has increased significantly. Especially for network access equipment, innovative solutions are required for heat dissipation to meet normal operation conditions of various components of terminal products, so that the products can function normally and provide satisfying experience for users.

The starting point of the embodiments of the present disclosure is based on the principle of heat dissipation through convection. An active convection air duct design is added without affecting the appearance, to allow a convection heat dissipation air duct of a product to make an adjustment according to a heat generation state of the product, and the air duct is designed to be as much as possible near components with high heat generation, thereby strengthening the air convection effect in key areas, shortening the length of the air duct to reduce the fan wind resistance, and optimizing the heat generation state of the product in different states, so as to maximize the hardware performance of the product and improve the performance of the product to meet user experience requirements of 5G products.

It is be noted that the heat dissipation device in the embodiments of the present disclosure is applicable to, in addition to 5G products, products and equipment that require heat dissipation in other application scenarios, for example, 4G-related products and equipment, other communication equipment, and hardware equipment such as computer equipment.

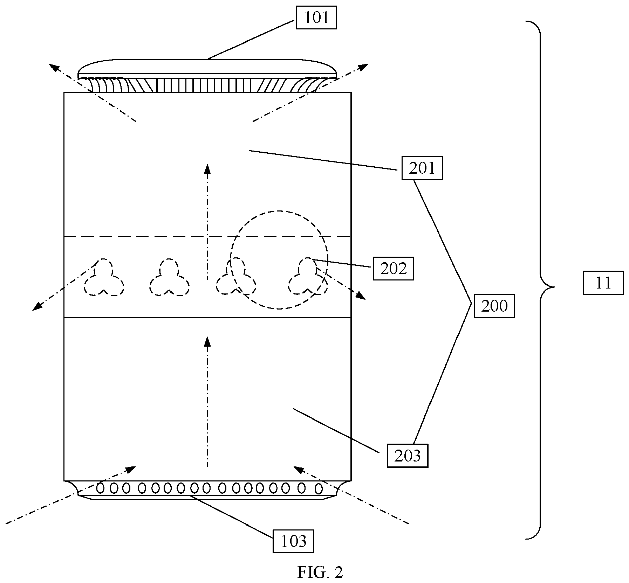

This embodiment provides a heat dissipation device. FIG. 2 is a schematic structural diagram of a heat dissipation device according to an embodiment of the present disclosure. As shown in FIG. 2, the heat dissipation device 11 includes a housing 200. The housing 200 includes a first sub-housing 201 and a second sub-housing 203. The second sub-housing 203 is adjacent to the bottom of the heat dissipation device 11, and the first sub-housing 201 is adjacent to the top of the heat dissipation device 11.

One or more holes 202 are provided in a part of the second sub-housing 203 overlapping the first sub-housing 201, and the first sub-housing 201 and the second sub-housing 203 are capable of relative movement. The relative movement is capable of exposing the one or more holes 202 provided in the second sub-housing 203 to form an air duct.

In some implementations of the present disclosure, the housing 200 may be provided surrounding an apparatus to be subjected to heat dissipation. The apparatus to be subjected to heat dissipation includes a bottom cover 103 at the bottom of the apparatus and a top cover 101 provided at the top of the apparatus. Air convection is formed between a hole provided in a groove at the bottom cover 103 and a hole provided in the top cover.

As can be seen, in the heat dissipation device 11 in this embodiment of the present disclosure, because the one or more holes 202 are provided in the part of the second sub-housing 203 overlapping the first sub-housing 201, in response to the relative movement between the first sub-housing 201 and the second sub-housing 203, the one or more holes 202 provided in the second sub-housing 203 may be exposed to form the air duct, so that the heat dissipation efficiency for the apparatus is improved, thereby solving the problem that in some cases a heat dissipation manner in which small holes are opened at the bottom and the top of the apparatus to allow cold air to be sucked in from the bottom and discharged from the top through convection to implement heat exchange has low heat dissipation efficiency.

It is to be noted that although the first sub-housing 201 and the second sub-housing 203 in the housing 200 of the heat dissipation device 11 in FIG. 2 may be integrally provided, that is, the housing of the entire heat dissipation device 11 is formed by one first sub-housing 201 and one second sub-housing 203, certainly, sub-housings that are not integrally provided may be used. That is, a separate first sub-housing 201 and a separate second sub-housing 203 are provided on every side, or the first sub-housing 201 and the second sub-housing 203 are only provided on one or more sides instead of that the first sub-housings 201 and the second sub-housings 203 are provided on all sides.

In addition, no hole is provided in the first sub-housings 201. Therefore, in a case that the first sub-housing 201 and the second sub-housing 203 overlap, the one or more holes 202 in the second sub-housings 203 are blocked, that is, the air duct cannot be formed for cooling. In addition, the shape of the one or more holes 202 in FIG. 2 is merely an example, and another shape may be used. For example, the one or more holes 202 may be one or more circular holes or one or more rectangular holes. The shape of the one or more holes 202 may be adjusted according to an actual requirement, and is not limited in the embodiments of the present disclosure.

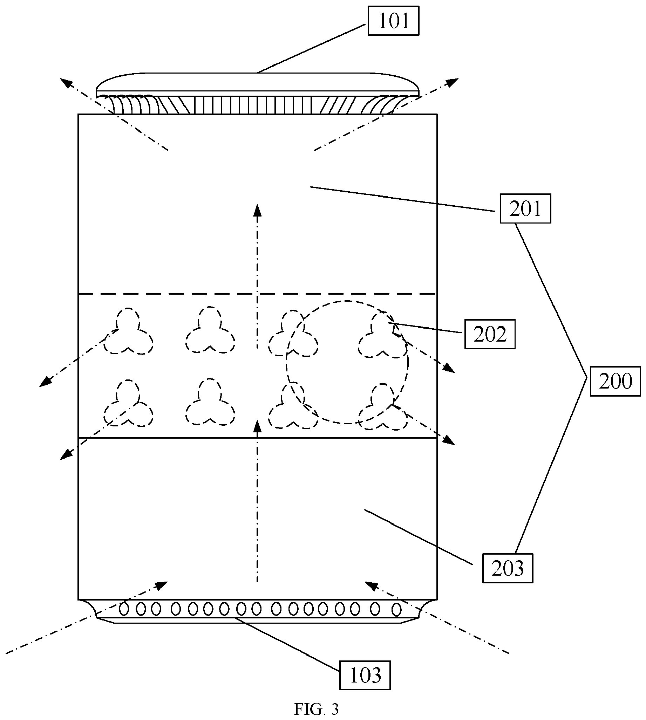

In addition, FIG. 2 only shows that there is only one row of holes 202 in the second sub-housing 203. This is merely an example for description. The quantity of holes and the quantity of rows of holes may be set according to an actual requirement. As shown in FIG. 3, two rows of holes 202 are provided in the second sub-housing 203.

It is to be noted that the one or more holes 202 in the second sub-housing 203 are provided in an area with relatively high heat generation of the apparatus, for example, a chip area. As shown in FIG. 2, a dashed circle corresponds to an area with relatively high heat generation of the apparatus. In this way, in a case of relatively high workload, heat dissipation can be performed in the area in time, thereby improving the heat dissipation effect for this area.

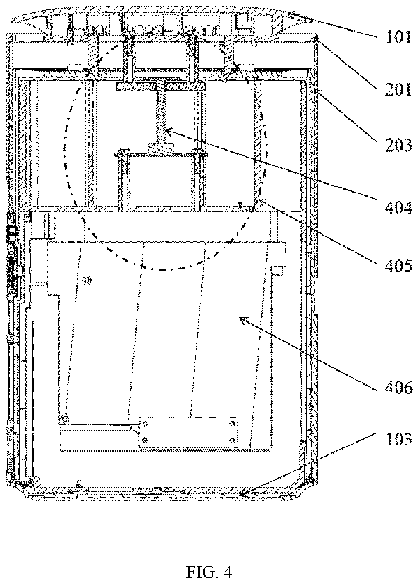

As shown in FIG. 4, the heat dissipation device further includes a mainboard support 405.

The mainboard support 405 is assembled in the second sub-housing 203 from the bottom of the heat dissipation device. The first sub-housing 201 is assembled in the second sub-housing 203 from the top of the heat dissipation device and is guided against an outer side wall of the second sub-housing 203. The mainboard support 405 is electrically connected to a mainboard 406 of the apparatus to be subjected to heat dissipation by a lead.

A screw rod 404 is provided on the mainboard support 405, and a screw rod sleeve 502 is provided on the screw rod 404. The screw rod 404 is fixedly connected to the mainboard support 405. The first sub-housing 201 is fixedly connected to the screw rod sleeve 502 of the screw rod 404. The manner of fixed connection may be a screw.

Rotation of the screw rod 404 is capable of driving the screw rod sleeve 502 to perform a reciprocating movement, and the reciprocating movement of the screw rod sleeve 502 drives the relative movement between the first sub-housing 201 and the second sub-housing 203.

In some implementations of the present disclosure, the heat dissipation device 11 further includes a drive motor. The drive motor is configured to receive a control instruction to drive the screw rod 404 to perform the rotation.

It is to be noted that a first control instruction is sent to the drive motor in response to a temperature of the apparatus to be subjected to heat dissipation placed in the housing 200 exceeding a first preset threshold. The first control instruction is configured to instruct the drive motor to drive the screw rod 404 to perform the rotation to bring about the relative movement between the first sub-housing 201 and the second sub-housing 203, to expose the one or more holes provided in the second sub-housing 203 to form the air duct. A second control instruction is sent to the drive motor in response to the temperature of the apparatus to be subjected to heat dissipation placed in the housing 200 being lower than a second preset threshold. The second control instruction is configured to instruct the drive motor to drive the screw rod 404 to perform the rotation to bring about the relative movement between the first sub-housing 201 and the second sub-housing 203, to cause the first sub-housing 201 to cover the one or more holes 202 in the second sub-housing 203.

Therefore, in an application scenario, after power up, the entire system operates. A temperature sensor inside a component detects an operating temperature at a critical position inside the component. When the temperature does not reach a preset start point, the system keeps a current state and continuously runs. Once it is detected that the temperature reaches a set high-temperature start point, the system drives the motor to bring about the relative movement between the first sub-housing 201 and the second sub-housing 203 to expose the one or more holes 202 provided in advance to form the air duct to accelerate heat dissipation, thereby ensuring reliable operation. Meanwhile, temperature detection is continuously performed. When it is detected that the temperature at the critical position drops and reaches a preset low-temperature start point, the system drives the motor to further drive the first sub-housing 201 to perform opposite movement relative to the second sub-housing 203, so that the first sub-housing 201 covers the one or more holes 202 in the second sub-housing 203, thereby closing the air duct and keeping continuous operation of the system. During the operation of the entire machine, temperature detection remains in an operating state. When a user turns off the system, a motor mechanism detects the position of the air duct, and the system is turned off after the air duct is closed.

That is, in a common usage scenario, cold air enters from the bottom, is heated by the mainboard 406, and is circulated to the top, to form convection cooling. In a long-time high-power consumption scenario, because the temperature in the chip area is excessively high, cold air cannot effectively reach the chip area. In this case, the first sub-housing 201 and the second sub-housing 203 are slid apart from each other by the motor under the control of a driver, to expose the one or more holes 202 for heat dissipation of the chip area. Cold air can quickly reach a heat generation area of a chip of the mainboard under the action of a fan to form convection cooling. In response to the temperature dropping to a preset temperature or the power consumption in the usage scenario decreasing, the driver controls the motor to pull the first sub-housing 201 and the second sub-housing 203 to return to an original state to ensure the original appearance, to avoid the impact of dust or the like because heat dissipation holes are exposed for a long time, thereby meeting an active heat dissipation requirement of the apparatus. The apparatus may be a 5G apparatus or other hardware equipment, so that the heat dissipation performance of a component under a critical operation condition is greatly improved, thereby improving user experience.

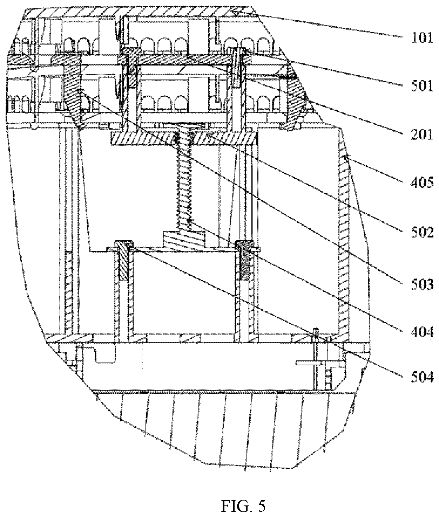

As shown in FIG. 5, a buckle 503 is provided on the first sub-housing. The buckle 503 is connected to the first sub-housing 201 and the second sub-housing 203.

In an application scenario, in response to the first sub-housing 201 moving under the drive of the screw rod 404 and the sleeve 502, in one aspect, the first sub-housing 201 is limited by a stroke of the screw rod 404, and in another aspect, a buckle 503 is used to ensure that during the movement of the first sub-housing 201 and the second sub-housing 203, the second sub-housing 203 and the first sub-housing 201 are prevented from being detached under an external force, thereby improving the assembly reliability of the entire machine. On an inner side of the buckle 503, a hole is provided in the first sub-housing 201. When repair is required, a fixture is used to pry open the buckle through the position of the hole, thereby separating the second sub-housing 203 and the first sub-housing 201 to repair the entire machine.

In addition, as shown in FIG. 5, after assembly, the first sub-housing 201 and the screw rod sleeve 502 are fixed by a screw 501. The screw rod 404 and the mainboard support 405 are fixed by a screw 504.

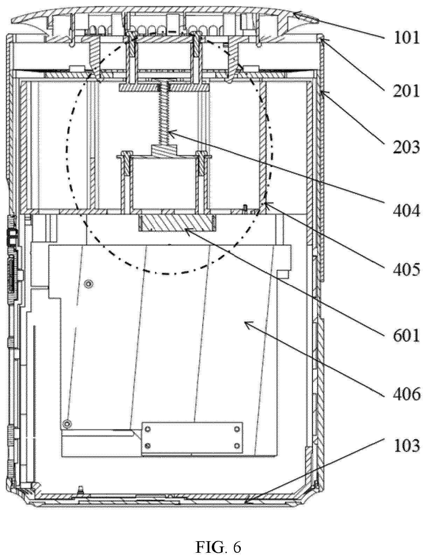

As shown in FIG. 6, a fan 601 is further provided on the mainboard support 405. An air duct of the fan 601 is consistent with the air duct formed by exposing the one or more holes 202 provided in the second sub-housing 203 through the relative movement.

That is, the screw rod 404 drives the first sub-housing 201 to slide relative to the second sub-housing 203 to expose the one or more holes 202 provided in advance. The exposed one or more holes 202 form the air duct to allow cold air to be effectively provided, so that the cold air can quickly reach a heat dissipation fin area, the air duct of the fan 601 is shortened, and the air pressure is reduced, thereby improving the efficiency of the fan 601 and extending the service life of the fan 601. It is to be noted that the position of the fan in the embodiments of the present disclosure may be adjusted and set according to the solution design and thermal design of a product.

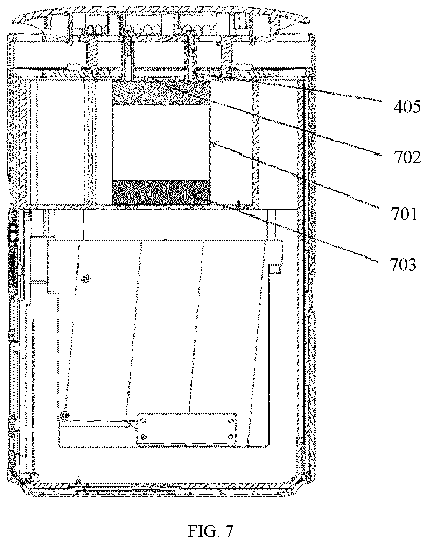

As shown in FIG. 7, a sleeve guide rail 701 is provided on the mainboard support 405. A first magnet 702 and a second magnet 703 are provided inside the sleeve guide rail 701. The first magnet 702 is provided at an end in the sleeve guide rail adjacent to the mainboard support 405, and the second magnet 703 is provided at an end in the sleeve guide rail away from the mainboard support 405. The mainboard support 405 is fixedly connected to the first sub-housing 201.

In an application scenario, the first magnet 702 may be a permanent magnet, and the second magnet 703 may be an electromagnet. The electromagnet is energized to adjust the magnetic poles of the electromagnet to cause the electromagnet and the permanent magnet to attract each other or repel each other to cause the mainboard support 405 to perform relative movement, so as to bring about the relative movement between the first sub-housing 201 and the second sub-housing 203.

Through the embodiments of the present disclosure, in the heat dissipation device in the embodiments of the present disclosure, because the one or more holes are provided in the part of the second sub-housing overlapping the first sub-housing, after the relative movement between the first sub-housing and the second sub-housing, the one or more holes provided in the second sub-housing may be exposed to form the air duct, so that the heat dissipation efficiency for the apparatus is improved, thereby solving the problem that in some cases a heat dissipation manner in which small holes are opened at the bottom and the top of the apparatus to allow cold air to be sucked in from the bottom and discharged from the top through convection to implement heat exchange has low heat dissipation efficiency.

Described above are merely some embodiments of the present disclosure, and are not intended to limit the present disclosure, which is defined in the appended claims. Within the principle of the present disclosure, any modifications, equivalent substitutions, improvements, and the like shall fall within the protection scope of the present disclosure, as long as it falls within the scope of the appended claims.

## Claims

1. A heat dissipation device (11), comprising a housing (200) and a mainboard support (405), wherein:
the housing (200) comprises a first sub-housing (201) and a second sub-housing (203), the second sub-housing (203) is configured to be adjacent to a bottom of the heat dissipation device (11), and the first sub-housing (201) is configured to be adjacent to a top of the heat dissipation device (11); and
one or more holes (202) are provided in a part of the second sub-housing (203) overlapping the first sub-housing (201), the first sub-housing (201) and the second sub-housing (203) are capable of relative movement, and the relative movement is capable of exposing the one or more holes (202) provided in the second sub-housing (203) to form an air duct;
wherein the mainboard support (405) is assembled in the second sub-housing (203) from the bottom of the heat dissipation device (11); the first sub-housing (201) is assembled in the second sub-housing (203) from the top of the heat dissipation device (11) and is guided against an outer side wall of the second sub-housing (203); and the mainboard support (405) is electrically connected by a lead to a mainboard (406) of an apparatus to be subjected to heat dissipation;
**characterized in that**,
a screw rod (404) is provided on the mainboard support (405), and a screw rod sleeve (502) is provided on the screw rod (404); the screw rod (404) is fixedly connected to the mainboard support (405); the first sub-housing (201) is fixedly connected to the screw rod sleeve (502) of the screw rod (404); and
rotation of the screw rod (404) is capable of driving the screw rod sleeve (502) to perform a reciprocating movement, and the reciprocating movement of the screw rod sleeve (502) drives the relative movement between the first sub-housing (201) and the second sub-housing (203).

2. The heat dissipation device (11) of claim 1, further comprising a drive motor, wherein:
the drive motor is configured to receive a control instruction to drive the screw rod (404) to perform the rotation.

3. The heat dissipation device (11) of claim 2, wherein:
a first control instruction is sent to the drive motor in response to a temperature of the apparatus to be subjected to heat dissipation placed in the housing (200) exceeding a first preset threshold, wherein the first control instruction is configured to instruct the drive motor to drive the screw rod (404) to perform the rotation to bring about the relative movement between the first sub-housing (201) and the second sub-housing (203), to expose the one or more holes (202) provided in the second sub-housing (203) to form the air duct; and
a second control instruction is sent to the drive motor in response to the temperature of the apparatus to be subjected to heat dissipation placed in the housing (200) being lower than a second preset threshold, wherein the second control instruction is configured to instruct the drive motor to drive the screw rod (404) to perform the rotation to bring about the relative movement between the first sub-housing (201) and the second sub-housing (203), to cause the first sub-housing (201) to cover the one or more holes (202) in the second sub-housing (203).

4. The heat dissipation device (11) of claim 1, wherein a buckle (503) is provided on the first sub-housing (201), and the buckle (503) is connected to the first sub-housing (201) and the second sub-housing (203).

5. The heat dissipation device (11) of claim 1, wherein a fan (601) is further provided on the mainboard support (405), and an air duct of the fan (601) is consistent with the air duct formed by exposing the one or more holes (202) provided in the second sub-housing (203) through the relative movement.

6. The heat dissipation device (11) of claim 1, wherein:
a sleeve guide rail (701) is provided on the mainboard support (405);
a first magnet (702) and a second magnet (703) are provided inside the sleeve guide rail (701); the first magnet (702) is provided at an end adjacent to the mainboard support (405) in the sleeve guide rail (701), and the second magnet (703) is provided at an end away from the mainboard support (405) in the sleeve guide rail (701); the mainboard support (405) is fixedly connected to the first sub-housing (201); and
the first magnet (702) and the second magnet (703) attract or repel each other to enable the mainboard support (405) to perform relative movement, to bring about the relative movement between the first sub-housing (201) and the second sub-housing (203).

## Patentansprüche

1. Wärmeableitungsvorrichtung (11), umfassend ein Gehäuse (200) und einen Hauptplatinenträger (405), wobei:
das Gehäuse (200) ein erstes Untergehäuse (201) und ein zweites Untergehäuse (203) umfasst, das zweite Untergehäuse (203) ausgestaltet ist, um an eine Unterseite der Wärmeableitungsvorrichtung (11) anzugrenzen, und das erste Untergehäuse (201) ausgestaltet ist, um an eine Oberseite der Wärmeableitungsvorrichtung (11) anzugrenzen; und
ein oder mehrere Löcher (202) in einem Teil des zweiten Untergehäuses (203) vorgesehen sind, der das erste Untergehäuse (201) überlappt, das erste Untergehäuse (201) und das zweite Untergehäuse (203) zu einer Relativbewegung in der Lage sind und die Relativbewegung in der Lage ist, das eine oder die mehreren Löcher (202) freizulegen, die in dem zweiten Untergehäuse (203) vorgesehen sind, um einen Luftkanal zu bilden;
wobei der Hauptplatinenträger (405) in das zweite Untergehäuse (203) von der Unterseite der Wärmeableitungsvorrichtung (11) eingebaut ist; das erste Untergehäuse (201) in das zweite Untergehäuse (203) von der Oberseite der Wärmeableitungsvorrichtung (11) eingebaut ist und gegen eine äußere Seitenwand des zweiten Untergehäuses (203) geführt wird; und der Hauptplatinenträger (405) durch eine Leitung mit einer Hauptplatine (406) eines Geräts, das der Wärmeableitung unterzogen werden soll, elektrisch verbunden ist;
**dadurch gekennzeichnet, dass**
eine Gewindestange (404) auf dem Hauptplatinenträger (405) vorgesehen ist und eine Gewindestangenhülse (502) auf der Gewindestange (404) vorgesehen ist; die Gewindestange (404) fest mit dem Hauptplatinenträger (405) verbunden ist; das erste Untergehäuse (201) fest mit der Gewindestangenhülse (502) der Gewindestange (404) verbunden ist; und
eine Drehung der Gewindestange (404) dazu in der Lage ist, die Gewindestangenhülse (502) anzutreiben, um eine hin- und hergehende Bewegung auszuführen, und die hin- und hergehende Bewegung der Gewindestangenhülse (502) die Relativbewegung zwischen dem ersten Untergehäuse (201) und dem zweiten Untergehäuse (203) antreibt.

2. Wärmeableitungsvorrichtung (11) nach Anspruch 1, ferner umfassend einen Antriebsmotor, wobei:
der Antriebsmotor ausgestaltet ist, um einen Steuerbefehl zu empfangen, um die Gewindestange (404) anzutreiben, um die Drehung auszuführen.

3. Wärmeableitungsvorrichtung (11) nach Anspruch 2, wobei:
ein erster Steuerbefehl zu dem Antriebsmotor als Reaktion darauf, dass eine Temperatur des Geräts, das einer Wärmeableitung unterzogen werden soll und in dem Gehäuse (200) platziert ist, einen ersten voreingestellten Schwellenwert überschreitet, gesendet wird, wobei der erste Steuerbefehl ausgestaltet ist, um den Antriebsmotor anzuweisen, die Gewindestange (404) anzutreiben, um die Drehung auszuführen, um die Relativbewegung zwischen dem ersten Untergehäuse (201) und dem zweiten Untergehäuse (203) zu bewirken, um das eine oder die mehreren Löcher (202), die in dem zweiten Untergehäuse (203) vorgesehen sind, freizulegen, um den Luftkanal zu bilden; und
ein zweiter Steuerbefehl zu dem Antriebsmotor als Reaktion darauf, dass die Temperatur des Geräts, das einer Wärmeableitung unterzogen werden soll und in dem Gehäuse (200) platziert ist, einen zweiten voreingestellten Schwellenwert unterschreitet, gesendet wird, wobei der zweite Steuerbefehl ausgestaltet ist, um den Antriebsmotor anzuweisen, die Gewindestange (404) anzutreiben, um die Drehung auszuführen, um die Relativbewegung zwischen dem ersten Untergehäuse (201) und dem zweiten Untergehäuse (203) zu bewirken, um zu bewirken, dass das erste Untergehäuse (201) das eine oder die mehreren Löcher (202) in dem zweiten Untergehäuse (203) abdeckt.

4. Wärmeableitungsvorrichtung (11) nach Anspruch 1, wobei eine Schnalle (503) an dem ersten Untergehäuse (201) vorgesehen ist und die Schnalle (503) mit dem ersten Untergehäuse (201) und dem zweiten Untergehäuse (203) verbunden ist.

5. Wärmeableitungsvorrichtung (11) nach Anspruch 1, wobei ferner ein Lüfter (601) an dem Hauptplatinenträger (405) vorgesehen ist und ein Luftkanal des Lüfters (601) mit dem Luftkanal übereinstimmt, der durch Freilegen des einen oder der mehreren Löcher (202), die in dem zweiten Untergehäuse (203) vorgesehen sind, durch die Relativbewegung gebildet wird.

6. Wärmeableitungsvorrichtung (11) nach Anspruch 1, wobei:
eine Hülsenführungsschiene (701) auf dem Hauptplatinenträger (405) vorgesehen ist;
ein erster Magnet (702) und ein zweiter Magnet (703) innerhalb der Hülsenführungsschiene (701) vorgesehen sind; der erste Magnet (702) an einem Ende angrenzend an den Hauptplatinenträger (405) in der Hülsenführungsschiene (701) vorgesehen ist und der zweite Magnet (703) an einem von dem Hauptplatinenträger (405) entfernten Ende in der Hülsenführungsschiene (701) vorgesehen ist; der Hauptplatinenträger (405) fest mit dem ersten Untergehäuse (201) verbunden ist; und
der erste Magnet (702) und der zweite Magnet (703) sich gegenseitig anziehen oder abstoßen, um den Hauptplatinenträger (405) in die Lage zu versetzen, eine Relativbewegung auszuführen, um die Relativbewegung zwischen dem ersten Untergehäuse (201) und dem zweiten Untergehäuse (203) zu bewirken.

## Revendications

1. Dispositif de dissipation de chaleur (11), comprenant un boîtier (200) et un support de carte mère (405), dans lequel :
le boîtier (200) comprend un premier sous-boîtier (201) et un deuxième sous-boîtier (203), le deuxième sous-boîtier (203) est configuré pour être adjacent à un fond du dispositif de dissipation de chaleur (11), et le premier sous-boîtier (201) est configuré pour être adjacent à un dessus du dispositif de dissipation de chaleur (11) ; et
un ou plusieurs trous (202) sont prévus dans une partie du deuxième sous-boîtier (203) chevauchant le premier sous-boîtier (201), le premier sous-boîtier (201) et le deuxième sous-boîtier (203) sont capables de mouvement relatif, et le mouvement relatif est capable d'exposer l'un ou plusieurs trous (202) prévus dans le deuxième sous-boîtier (203) pour former un conduit d'air ;
dans lequel le support de carte mère (405) est assemblé dans le deuxième sous-boîtier (203) à partir du fond du dispositif de dissipation de chaleur (11) ; le premier sous-boîtier (201) est assemblé dans le deuxième sous-boîtier (203) depuis le dessus du dispositif de dissipation de chaleur (11) et est guidé contre une paroi latérale externe du deuxième sous-boîtier (203) ; et le support de carte mère (405) est relié électriquement par un fil à une carte mère (406) d'un appareil devant être soumis à une dissipation de chaleur ;
**caractérisé en ce que**,
une tige filetée (404) est prévue sur le support de carte mère (405), et un manchon de tige filetée (502) est prévu sur la tige filetée (404) ; la tige filetée (404) est reliée de manière fixe au support de carte mère (405) ; le premier sous-boîtier (201) est relié de manière fixe au manchon de tige filetée (502) de la tige filetée (404) ; et
la rotation de la tige filetée (404) est capable d'entraîner le manchon de tige filetée (502) pour effectuer un mouvement alternatif, et le mouvement alternatif du manchon de tige filetée (502) entraîne le mouvement relatif entre le premier sous-boîtier (201) et le deuxième sous-boîtier (203).

2. Dispositif de dissipation de chaleur (11) de la revendication 1, comprenant en outre un moteur d'entraînement, dans lequel :
le moteur d'entraînement est configuré pour recevoir une instruction de commande pour entraîner la tige filetée (404) pour effectuer la rotation.

3. Dispositif de dissipation de chaleur (11) de la revendication 2, dans lequel :
une première instruction de commande est envoyée au moteur d'entraînement en réponse à une température de l'appareil devant être soumis à une dissipation de chaleur placé dans le boîtier (200) dépassant un premier seuil prédéfini, dans lequel la première instruction de commande est configurée pour commander au moteur d'entraînement d'entraîner la tige filetée (404) pour effectuer la rotation afin de provoquer le mouvement relatif entre le premier sous-boîtier (201) et le deuxième sous-boîtier (203), pour exposer l'un ou plusieurs trous (202) prévus dans le deuxième sous-boîtier (203) pour former le conduit d'air ; et
une deuxième instruction de commande est envoyée au moteur d'entraînement en réponse à la température de l'appareil devant être soumis à une dissipation de chaleur placé dans le boîtier (200) étant inférieure à un deuxième seuil prédéfini, dans lequel la deuxième instruction de commande est configurée pour commander au moteur d'entraînement d'entraîner la tige filetée (404) pour effectuer la rotation afin de provoquer le mouvement relatif entre le premier sous-boîtier (201) et le deuxième sous-boîtier (203), pour amener le premier sous-boîtier (201) à couvrir l'un ou plusieurs trous (202) dans le deuxième sous-boîtier (203).

4. Dispositif de dissipation de chaleur (11) selon la revendication 1, dans lequel une boucle (503) est prévue sur le premier sous-boîtier (201), et la boucle (503) est reliée au premier sous-boîtier (201) et au deuxième sous-boîtier (203).

5. Dispositif de dissipation de chaleur (11) de la revendication 1, dans lequel un ventilateur (601) est en outre prévu sur le support de carte mère (405), et un conduit d'air du ventilateur (601) est compatible avec le conduit d'air formé en exposant l'un ou plusieurs trous (202) prévus dans le deuxième sous-boîtier (203) grâce au mouvement relatif.

6. Dispositif de dissipation de chaleur (11) de la revendication 1, dans lequel :
un rail de guidage de manchon (701) est prévu sur le support de carte mère (405) ;
un premier aimant (702) et un deuxième aimant (703) sont prévus à l'intérieur du rail de guidage de manchon (701) ; le premier aimant (702) est prévu à une extrémité adjacente au support de carte mère (405) dans le rail de guidage de manchon (701), et le deuxième aimant (703) est prévu à une extrémité éloignée du support de carte mère (405) dans le rail de guidage de manchon (701) ; le support de carte mère (405) est relié de manière fixe au premier sous-boîtier (201) ; et
le premier aimant (702) et le deuxième aimant (703) s'attirent ou se repoussent mutuellement pour permettre au support de carte mère (405) d'effectuer un mouvement relatif, pour provoquer le mouvement relatif entre le premier sous-boîtier (201) et le deuxième sous-boîtier (203).
